# EUROPEAN PATENT APPLICATION

(11) **EP 3 428 958 A1**
(43) Date of publication of application: **16.01.2019**
(21) Application number: 17762937.5
(22) Date of filing: 23.02.2017
(51) Int. Cl.: H01L 21/265, H01L 21/268

(54) **HEAT TREATMENT DEVICE, HEAT TREATMENT METHOD, LASER ANNEALING DEVICE, AND LASER ANNEALING METHOD**

(30) Priority: 09.03.2016 JP 2016045346
(71) Applicant: Mitsubishi Electric Corporation, Chiyoda-ku Tokyo 100-8310 (JP)
(72) Inventor: MONODANE, Takeshi, Tokyo 100-8310 (JP); KAWASE, Yusuke, Tokyo 100-8310 (JP); MINATO, Tadaharu, Tokyo 100-8310 (JP); TAKENO, Shozui, Tokyo 100-8310 (JP); NAGAYAMA, Takahisa, Tokyo 100-8310 (JP); MINAMITAKE, Haruhiko, Tokyo 100-8310 (JP); KANADA, Kazunori, Fukuoka-shi Fukuoka 819-0192 (JP); TATSUMI, Hiroaki, Tokyo 100-8310 (JP)
(74) Representative: Sajda, Wolf E.
(86) International application number: PCT/JP2017/006868
(87) International publication number: WO 2017/154597

(57) **Abstract**

Provided is a heat treatment device including: a laser oscillator (1) configured to produce a laser; one or more optical systems (2) each configured to irradiate an object (5) to be treated with the laser produced from the laser oscillator (1); and a rotating table (3) on which the object (5) is to be mounted. When a reaching temperature of the object (5), at which an activation rate of the object (5) reaches a target value through one-time irradiation with the laser, is set as a first temperature, a second temperature lower than the first temperature is set as a target value of the reaching temperature of the object (5), and the object (5) is repeatedly irradiated with the laser from one of the one or more optical systems (2) two or more times.

## Description

### Technical Field

The present invention relates to a heat treatment device, a heat treatment method, a laser annealing device, and a laser annealing method, and more particularly, to a heat treatment device, a heat treatment method, a laser annealing device, and a laser annealing method for performing heat treatment by irradiating an object to be treated with a laser.

### Background Art

In a manufacturing process of a semiconductor device, a semiconductor substrate is subjected to heat treatment up to a desired depth in some cases. For example, in Patent Literature 1, there is disclosed a method of manufacturing an insulated gate bipolar transistor (IGBT) used for switching of electric power. In this method, diffusion regions such as a base region and an emitter region, electrodes such as an emitter electrode and a gate electrode, and insulation films such as a gate insulator and an interlayer insulation film are formed on a front surface of a conductive silicon substrate, and diffusion regions such as a field stop layer and a collector layer are formed on a back surface of the conductive silicon substrate. In this case, the field stop layer and the collector layer on the back surface are doped with impurity atoms by ion implantation or the like, and the doped regions are required to be subjected to heat treatment of increasing the temperature of the doped regions to a certain temperature or higher.

However, the diffusion regions, the electrodes, and the insulation films described above are formed on the front surface of the substrate, and when the substrate surface is increased in temperature, the functions of the diffusion regions, the electrodes, and the insulation films are lost. Therefore, when the back surface is subjected to heat treatment, and a temperature increase caused by the heat treatment is transmitted to the front surface through heat conduction, the function of the front surface is lost.

For this reason, the heat treatment of the back surface is required to be performed so as to locally heat the back surface. In view of the foregoing, in Patent Literature 1 and Patent Literature 2, for example, there has been proposed the use of a laser annealing method of irradiating a silicon surface with a laser to increase the temperature of only a surface layer. However, in an IGBT, the characteristics of the diffusion regions of the back surface vary depending on the thicknesses thereof, and in general, as the thickness of the field stop layer becomes larger, withstand voltage characteristics increase.

In view of this, in Patent Literature 3, there is disclosed that a semiconductor substrate can be increased in temperature to a desired temperature up to a desired depth through use of two lasers having different wavelengths in laser annealing. However, in recent years, a substrate has been reduced in thickness, and the substrate surface is increased in temperature even by local heating with a laser, with the result that thermal damage to a circuit occurs. In order to solve this problem, it is required to input heat for a short time period, and in the above-mentioned Patent Literature 2, heat can be input locally for a short time period by rotating a table at a high speed.

### List of Citations

### Patent Literature

[PTL 1] JP 2003-059856 A
[PTL 2] JP 2013-074246 A
[PTL 3] JP 4 117 020 B2

### Summary of the Invention

### Technical Problem

As described above, in the IGBT, as the thickness of the field stop layer becomes larger, the characteristics thereof are improved. However, when the back surface is irradiated with a laser by the devices described in Patent Literature 1 and Patent Literature 2, only the surface layer is increased in temperature, and hence there is a problem in that it is difficult to increase the temperature of a deep position having a certain depth or more.

Further, when a laser having a wavelength with a large attenuation length is used as in Patent Literature 3, the energy of the laser can reach an inner portion, and hence the substrate can be increased in temperature up to a position having a certain depth. However, due to the characteristics of the laser that the energy on a front surface of an irradiation surface is largest, the temperature of the surface layer becomes highest.

When the front surface reaches a melting point, the crystal structure or shape of the front surface is disturbed, and hence electrical characteristics as a semiconductor significantly change, with the result that the substrate cannot be used as a semiconductor product. Therefore, even when a laser with a large attenuation length is used, a position having a certain depth or more cannot be increased in temperature due to the constraint of the condition of causing the front surface to reach the melting point. Further, two light sources having different wavelengths are required, and hence the device becomes complicated.

Further, in recent years, a substrate has been further reduced in thickness so as to have a thickness of 100 µm or less. Therefore, when the back surface is irradiated with a laser, the temperature on a front side of the substrate is also increased, causing damage to a circuit or a protective tape on the front side of the substrate. Thus, there is a problem in that laser annealing treatment cannot be performed on a substrate having a certain thickness or less.

The present invention has been made to solve the above-mentioned problems, and an object of the present invention is to obtain a heat treatment device, a heat treatment method, a laser annealing device, and a laser annealing method, which are capable of reducing thermal damage to a surface to be irradiated of an object to be treated and activating the object to be treated up to a region having a desired depth.

### Solution to the Problems

According to one embodiment of the present invention, there is provided a heat treatment device including: a laser oscillator configured to produce a laser; one or more optical systems each configured to irradiate an object to be treated with the laser produced from the laser oscillator; and a table on which the object to be treated is to be mounted, in which, when a reaching temperature of the object to be treated, at which an activation rate of the object to be treated reaches a target value through one-time irradiation with the laser, is set as a first temperature, a second temperature lower than the first temperature is set as a target value of the reaching temperature of the object to be treated, and the object to be treated is repeatedly irradiated with the laser from one of the one or more optical systems two or more times.

### Advantageous Effects of the Invention

According to one embodiment of the present invention, when the reaching temperature of the object to be treated, at which the activation rate of the object to be treated reaches the target value through one-time irradiation with the laser, is set as the first temperature, the second temperature lower than the first temperature is set as the target value of the reaching temperature of the object to be treated, and the object to be treated is repeatedly irradiated with the laser two or more times. Therefore, the object to be treated can be activated up to a region having a desired depth while thermal damage to a surface to be irradiated of the object to be treated is reduced, and a temperature increase of a surface on a side opposite to the surface to be irradiated of the object to be treated is prevented.

### Brief Description of the Drawings

- FIG. 1A: is a side view for illustrating a configuration of a heat treatment device according to a first embodiment and a second embodiment of the present invention.
- FIG. 1B: is a plan view for illustrating the configuration of the heat treatment device according to the first embodiment and the second embodiment of the present invention.
- FIG. 2: is an explanatory graph for showing an activation rate for each depth of an object to be treated with heat treatment of the heat treatment device according to the first embodiment and the second embodiment of the present invention.
- FIG. 3: is a partially enlarged side view for illustrating the configuration of the heat treatment device according to the first embodiment and the second embodiment of the present invention.
- FIG. 4: is a flowchart for illustrating a process flow of a heat treatment method according to the first embodiment and the second embodiment of the present invention.
- FIG. 5A: is a side view for illustrating a configuration of a heat treatment device according to a third embodiment and a fourth embodiment of the present invention.
- FIG. 5B: is a plan view for illustrating the configuration of the heat treatment device according to the third embodiment and the fourth embodiment of the present invention.
- FIG. 6: is a plan view for illustrating a configuration of a heat treatment device according to a fifth embodiment and a sixth embodiment of the present invention.
- FIG. 7: is a plan view for illustrating a configuration of a heat treatment device according to a seventh embodiment of the present invention.

### Description of Embodiments

Now, each embodiment of the present invention is described with reference to the drawings. Before describing each embodiment, the concept of each embodiment of the present invention is first described.

Each embodiment of the present invention relates to a heat treatment device and a heat treatment method for sufficiently activating an object to be treated by increasing the temperature of the object to be treated from a surface to a desired depth thereof to a desired temperature without causing damage to the object to be treated.

A phenomenon in which sufficient activation is achieved by repeatedly heating even at a low temperature was found this time, and hence, in each embodiment of the present invention, through use of this phenomenon, a temperature lower than a set temperature of laser annealing that has hitherto been performed is set as a target value, and the object to be treated is repeatedly irradiated with a laser so that the temperature reaches the target value, to thereby activate the object to be treated up to a deep region.

In each of the following embodiments of the present invention, description is given assuming that the object to be treated is a semiconductor. Activation of the object to be treated is treatment of increasing the temperature of the semiconductor being the object to be treated implanted with impurities, to cause the impurities to function as P-type junction and N-type junction.

The activation rate of activation has hitherto been considered to be determined based only on the highest reaching temperature of the object to be treated. However, the following results were obtained this time. The object to be treated is sufficiently activated when a temperature increase repeatedly occurs even at a low temperature without depending only on the highest reaching temperature.

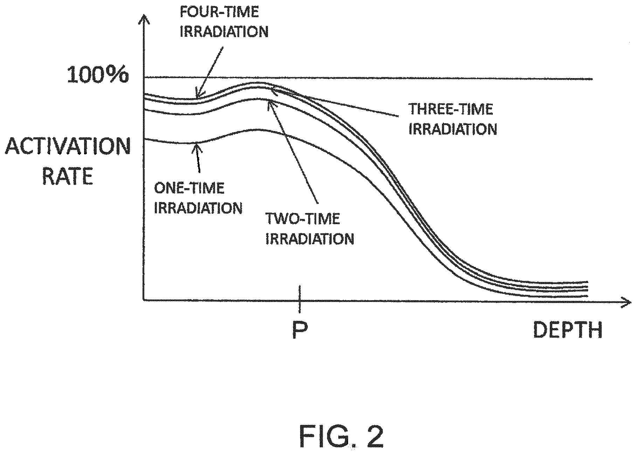

The results are shown in FIG. 2. In FIG. 2, the horizontal axis represents a depth of the object to be treated from the surface thereof, and the vertical axis represents an activation rate of the object to be treated. As shown in FIG. 2, the activation rate was about 70 % with first irradiation. This case is considered as a shortage of heat input in the related art, and thus a laser output is to be increased.

However, when second irradiation was performed with the same output and under the same irradiation condition as those of the first irradiation, the activation rate reached 90 %. When irradiation was repeatedly performed, that is, third irradiation and fourth irradiation were performed, the activation rate reached 95 % or more, which was considered as a sufficient activation rate. That is, it has been found that sufficient activation is obtained by repeatedly performing irradiation with a lower temperature increase instead of one-time temperature increase.

Namely, for example, when a temperature at which sufficient activation is performed with one-time irradiation is 100, sufficient activation was performed by repeatedly performing irradiation four times at a temperature of 70 in theory. In general, laser annealing to a silicon wafer involves increasing a temperature to the vicinity of a melting point of the silicon wafer, and hence defects caused by melting or thermal stress occur. However, such defects do not occur with repeated irradiation at a low temperature.

Further, it is required to increase a temperature increase at a deep position in order to activate also the deep position. Therefore, in general, it is required to increase input energy. When the input energy is increased, a temperature increase of an outermost surface is inevitably caused, with the result that melting occurs, and thermal stress is also increased. Further, in recent years, a substrate has been reduced in thickness. As the substrate becomes thinner, a temperature increase on a side opposite to a side subjected to laser irradiation is increased, with the result that it becomes difficult to perform laser annealing treatment due to thermal damage to peripheral components such as a protective tape.

However, in each of the following embodiments of the present invention, the object to be treated can be activated by repeatedly causing a temperature increase at a low temperature. Therefore, even a deep position from the surface of the object to be treated can be sufficiently activated without increasing the temperature of an irradiation surface.

This is shown in the results of the graph of FIG. 2. The following is understood. For example, at a position having a depth P of FIG. 2, the activation rate at the position having the depth P is significantly low with one-time irradiation, but the activation rate is remarkably improved after the second irradiation. Then, a sufficient activation rate is obtained by repeatedly performing irradiation, that is, performing the third irradiation and the fourth irradiation.

In each of the following embodiments of the present invention, a desired activation rate can be achieved up to a desired depth while melting of the irradiation surface is suppressed, and occurring thermal stress is reduced. Further, a temperature increase of a circuit on the surface of the substrate corresponding to the surface on a side opposite to the irradiation side is also suppressed, and hence each of the embodiments can also be applied to a thin substrate.

As described above, with the heat treatment device and the heat treatment method according to each of the following embodiments of the present invention, a deep region of the object to be treated can also be activated through use of a simple device configuration by repeatedly performing irradiation with a laser at a low temperature without causing damage to the object to be treated.

### First Embodiment

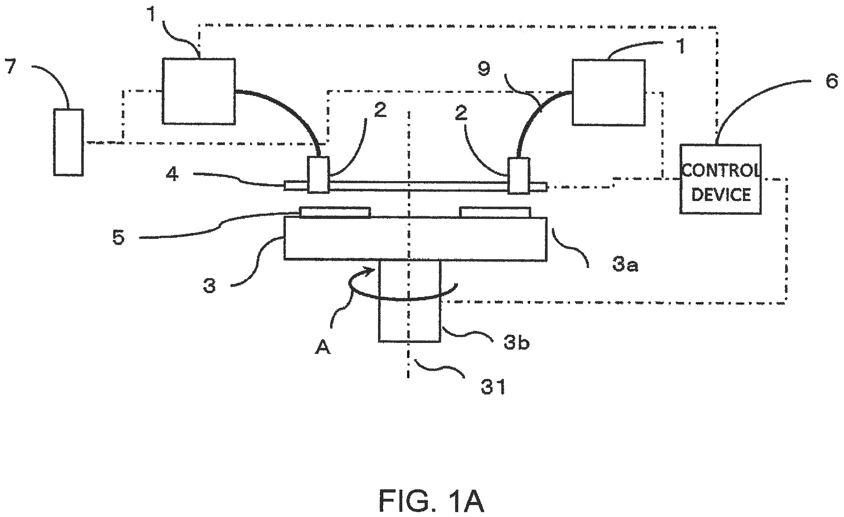

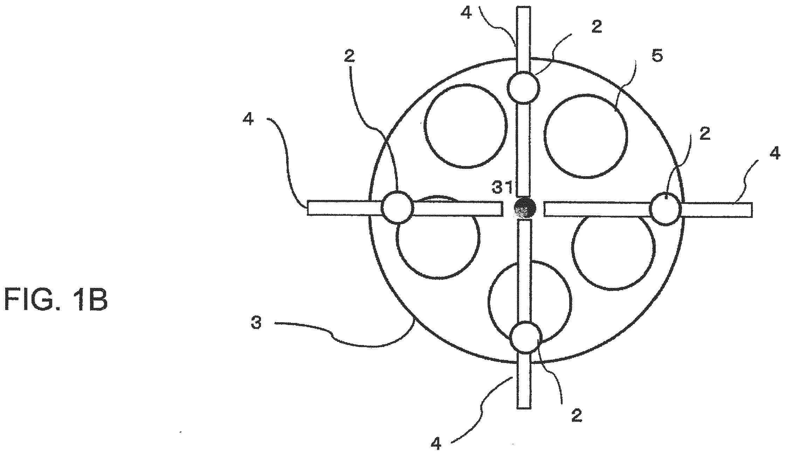

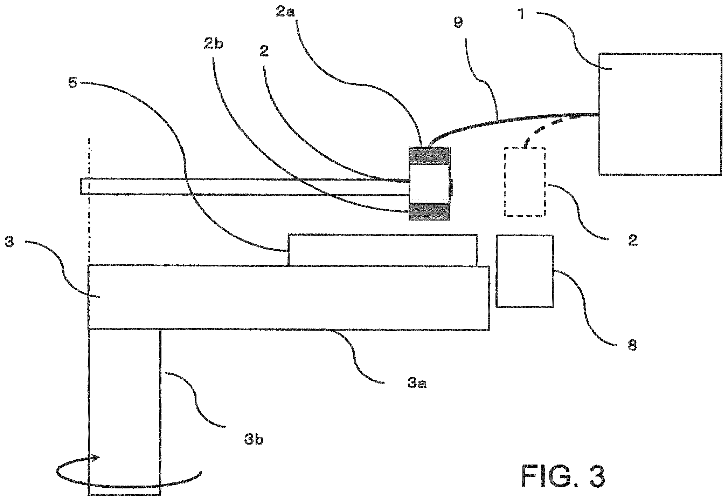

FIG. 1A and FIG. 1B are each a configuration view for illustrating a configuration of a heat treatment device according to a first embodiment of the present invention. FIG. 1A is a side view of the heat treatment device, and FIG. 1B is a plan view of the heat treatment device. FIG. 2 is a graph for showing an activation rate obtained by the heat treatment device according to the first embodiment. Further, FIG. 3 is a partially enlarged view for illustrating the configuration of the heat treatment device according to the first embodiment.

As illustrated in FIG. 1A and FIG. 1B, in the heat treatment device according to the first embodiment, one or more laser oscillators 1 are disposed. In FIG. 1A and FIG. 1B, two laser oscillators 1 are disposed, but the present invention is not limited thereto. Only one laser oscillator 1 may be disposed, or three or more laser oscillators 1 may be disposed. The laser oscillator 1 produces a laser with which an object to be treated is irradiated. One or more optical systems 2 are connected to the laser oscillator 1 through a fiber core 9.

The laser produced by the laser oscillator 1 is transmitted to the optical system 2 through the fiber core 9. The optical system 2 irradiates an object 5 to be treated with the laser. As illustrated in FIG. 3, the optical system 2 includes a collimation lens 2a and an objective lens 2b. In the optical system 2, the collimation lens 2a and the objective lens 2b condense the laser to irradiate the object 5 to be treated with the laser. The objective lens 2b serves an irradiation port of the optical system 2. A rotating table 3 is set so as to be opposed to the irradiation port of the optical system 2.

One or more objects 5 to be treated are mounted on the rotating table 3. The rotating table 3 includes a main body 3a and a support shaft 3b. The main body 3a of the rotating table 3 has a disc shape as illustrated in the plan view of FIG. 1B. In the rotating table 3, the main body 3a and the support shaft 3b are integrally fixed. Thus, when the support shaft 3b is rotated in a direction of an arrow A with a center 31 being a center axis, the main body 3a is also rotated in a circumferential direction in synchronization with the rotation of the support shaft 3b.

A drive system 4 is disposed with respect to the optical system 2. The drive system 4 moves the optical system 2 in a radial direction of the rotating table 3, that is, on a radius line. Specifically, the drive system 4 moves the optical system 2 from the center 31 of the rotating table 3 to an outer side, or from the outer side to the center 31. Further, a control device 6 configured to drive and control the drive system 4 and the rotating table 3 is disposed. Further, an output measurement instrument 7 configured to monitor an output of the laser oscillator 1 is installed. Further, as illustrated in FIG. 3, a beam shape measurement instrument 8 configured to monitor a beam shape of the laser emitted from the optical system 2 is disposed.

Only one optical system 2 may be disposed. However, in order to heat a plurality of objects to be treated efficiently within a short time period, it is desired that two or more optical systems 2 be disposed if possible. Further, a pair of optical systems 2 may be disposed on one diameter line of the rotating table 3. However, in the first embodiment, as illustrated in FIG. 1B, each pair of optical systems 2 is disposed on each of two straight lines crossing each other perpendicularly.

That is, in the first embodiment, as illustrated in FIG. 1B, four optical systems 2 are disposed so as to form an angle of 90° with respect to each other. The drive system 4 is disposed with respect to each of the optical systems 2.

Therefore, in the first embodiment, as illustrated in FIG. 1B, four drive systems 4 are disposed so as to form an angle of 90° with respect to each other. Thus, when the drive systems 4 are disposed so as to form an angle of 90° with respect to each other, it becomes easy to calculate the position of the optical system 2 in the control device 6, and a laser scanning mechanism can be accurately disposed.

In the first embodiment, the object 5 to be treated is assumed to be a silicon wafer implanted with impurities from the surface to a region of from several micrometers to several tens of micrometers by ion implantation, but the present invention is not limited thereto. The first embodiment is also applicable to another object to be treated other than the silicon wafer, for example, a TFT.

Further, heat treatment is assumed to be laser annealing treatment, but the present invention is not limited thereto. The first embodiment is applicable to all kinds of heat treatment using a laser. The laser annealing treatment is heat treatment for obtaining desired characteristics of an object to be treated by changing crystal orientation of the object to be treated through use of heat.

In the first embodiment, it is assumed that a fiber transmission type laser diode (LD) laser is used as the laser oscillator 1. Through use of the fiber transmission type LD laser, the optical system 2 can be simplified. Further, the optical system 2 and the laser oscillator 1 are connected to each other through the fiber core 9 having flexibility.

Therefore, there is flexibility in the relative positional relationship between the optical system 2 and the laser oscillator 1, with the result that the position of the optical system 2 can be freely set, and the optical system 2 can be easily driven. As described above, in the first embodiment, there is employed a mechanism in which the laser from the laser oscillator 1 is transmitted to the optical system 2 through the fiber core 9 and condensed by the collimation lens 2a and the objective lens 2b, which form the optical system 2, and the object 5 to be treated is irradiated with the laser.

Next, a heat treatment method according to the first embodiment is described. In the first embodiment, the object 5 to be treated is irradiated with a laser having a value obtained by dividing a power density (W/cm²) being a heat input amount per unit time and unit volume by a scanning speed. In this case, the object 5 to be treated is irradiated with the laser so that a value obtained by dividing an output W of the laser from the laser oscillator 1 by an irradiation area S of the laser and further dividing the resultant by a scanning speed V, that is, W/(S×V) becomes constant over the entire surface of the object 5 to be treated.

In the first embodiment, when a reaching temperature of the object 5 to be treated, at which the activation rate of the object to be treated reaches 90 % or 95 % being a target value through one-time irradiation with the laser, is 100, a value lower than 100, for example, 70, is set as a target value of the reaching temperature of the object to be treated, and the object 5 to be treated is repeatedly irradiated with the laser two or more times.

The number of times of repetition may be freely set, but two or more times and four or less times are considered to be desired with reference to the results of FIG. 2. Further, the value "70" is also merely one example, and a value of from about 60 to about 80 is desired. Thus, a target activation rate is obtained by setting the target value of the reaching temperature to a low temperature, setting the power density of the laser so that the temperature of the object to be treated reaches the target value, and repeatedly performing laser irradiation.

In the first embodiment, as illustrated in FIG. 1B, the rotating table 3 is rotated under a state in which the objects 5 to be treated are mounted on the rotating table 3, and the objects 5 to be treated are irradiated with the laser by the optical systems 2. Thus, when the rotating table 3 is rotated by one turn, a band-shaped region having a width corresponding to a beam diameter of the laser can be subjected to heat treatment along a circumferential direction of the rotating table 3 in a surface to be irradiated of each of the objects 5 to be treated.

Thus, the rotating table 3 is rotated by one turn during the laser irradiation, and then the treatment of moving each of the optical systems 2 in a radial direction of the rotating table 3 by the width corresponding to the beam diameter with the drive system 4 is repeated, with the result that the entire surface of each of the objects 5 to be treated can be subjected to heat treatment. In the above description, the optical system 2 is moved for each rotation, but it is not required that the optical system 2 be moved for each rotation, and the optical system 2 may be moved for every predefined number of rotations, for example, for every two rotations.

In this case, when the rotation speed of the rotating table 3 is constant, the peripheral speed of the object 5 to be treated is proportional to the radius of the rotating table 3. Therefore, as the irradiation position of the laser is brought closer to the rotation center, the peripheral speed is decreased, and hence it is required to decrease the output of the laser. Further, when the output of the laser is constant, it is required to increase the rotation speed as the irradiation position is brought closer to the center. In general, the output of the laser does not have satisfactory responsiveness.

Therefore, in an optimum embodiment, the output of the laser is set to be constant, and the rotation speed is changed in accordance with the irradiation position of the laser, that is, in accordance with the position of the optical system 2. In this manner, the relative moving speed between the optical system 2 and the object 5 to be treated becomes always constant, and the power density with respect to the irradiation position can be set to be constant. Specifically, as the position of the optical system 2 is brought closer to the center 31, the rotation speed is increased.

In the first embodiment, the control device 6 reads the irradiation position of the optical system 2 from the current position of the drive system 4, and the relationship between the peripheral speed and the rotation speed is a relationship: v = 2πrw, where v represents the peripheral speed, r represents the radius, and w represents the rotation speed.

Therefore, based on this relationship, the control device 6 controls the rotation speed of the rotating table 3 so as to achieve a target value of a desired peripheral speed. With this, the same temperature increase is obtained at all the irradiation positions of the object 5 to be treated.

As the scanning speed of the laser is higher, a thermally influenced portion becomes smaller, and hence the increase temperature on a surface opposite to a surface subjected to the laser irradiation is decreased. Further, when the beam diameter is decreased, the total heat input amount can be reduced even at the same highest reaching temperature, and hence the increase temperature on the surface opposite to the surface subjected to the laser irradiation can also be decreased.

Therefore, as the scanning speed is higher, and the beam diameter is smaller, thermal damage to the object 5 to be treated can be reduced, and the first embodiment can also be applied to a thin object to be treated. For the purpose of increasing the scanning speed, it is reasonable to increase the scanning speed by mounting a plurality of objects 5 to be treated on one rotating table 3 and rotating the rotating table 3 as described in the first embodiment. When one object 5 to be treated is rotated, the peripheral speed becomes excessively low in the vicinity of the center 31.

Further, the object 5 to be treated may be linearly moved in a relative manner instead of being rotated. However, when the object 5 to be treated is linearly moved, the object 5 to be treated is definitely required to be reciprocated, and a return operation occurs. As the speed is increased, an inertial force at the time of return is increased, and a suspension time and an acceleration time are taken, with the result that the efficiency of the treatment is degraded. Thus, the efficiency of the treatment can be enhanced by rotating the object 5 to be treated as described in the first embodiment as compared to a configuration of linearly moving the object 5 to be treated.

However, as a matter of course, the first embodiment is not limited to rotating the object 5 to be treated and is also applicable to the configuration of linearly moving the object 5 to be treated. Even when the object 5 to be treated is linearly moved, the relative moving speed between the optical system 2 and the object 5 to be treated is controlled so that the beam scanning speed becomes constant at all the irradiation positions in such a manner that the same power density is obtained at all the irradiation positions.

In this case, it is appropriate that the peripheral speed be from about 100 m/min to about 800 m/min, the beam output be from about 10 W to about 80 W, and the beam diameter be from about ϕ50 µm to about ϕ300 µm. Further, as the number of the objects 5 to be treated, which are mounted on the rotating table 3, is increased, the number of the objects 5 to be treated, which can be treated at once, is increased, and the efficiency is enhanced.

However, the radius of the rotating table 3 is increased, and the centrifugal force is increased, causing problems in vibration and stiffness. Therefore, in order to obtain the above-mentioned peripheral speed, it is appropriate that about five to about nine objects 5 to be treated be mounted.

As illustrated in FIG. 1A and FIG. 1B, a plurality of laser oscillators 1 and a plurality of optical systems 2 are mounted with respect to one rotating table 3, and the objects 5 to be treated are simultaneously irradiated with a plurality of lasers. In this case, as described above, it is required to set a value obtained by dividing the heat input amount (W/cm²) per unit time and unit volume by the peripheral speed to be constant.

The peripheral speed in this case serves as the scanning speed of the laser. Therefore, the outputs of the lasers emitted from the plurality of optical systems 2 are set to be uniform to one another, and the distances between the irradiation positions of the plurality of optical systems 2 and the center 31 are set to be equal to one another. The outputs of the lasers are adjusted by monitoring all the laser oscillators 1 with the output measurement instrument 7.

Further, in order to set the diameters of the beams emitted from the optical systems 2 to be constant, as illustrated in FIG. 3, the beam shape measurement instrument 8 is mounted and the beam shape of each of the lasers is monitored. A part of the beams may be taken out through use of a beam splitter or the like to be monitored during the treatment. However, in general, the beam shape is not abruptly changed, and hence, as illustrated in FIG. 3, the beam shape measurement instrument 8 is set at a position away from the object 5 to be treated and checks the beam shape before the treatment.

In order to set the distances between the irradiation positions of the lasers from all the optical systems 2 and the center 31 in the radial direction to be equal to one another, the drive systems 4 configured to drive the optical systems 2 are disposed radially from the center 31 as illustrated in FIG. 1B, and all the optical systems 2 are positioned radially.

That is, all the optical systems 2 are disposed concentrically with respect to the center 31. The control device 6 controls the drive systems 4 so that the distances between the irradiation positions of all the optical systems 2 and the center 31 become equal to one another, and simultaneously moves all the optical systems 2 radially by the same distance. That is, when the four optical systems 2 are initially positioned on the outermost side, for example, the four optical systems 2 are gradually moved toward the center 31 by the same distance every time the rotating table 3 is rotated by one turn.

With this, the entire surface of each of the plurality of objects 5 to be treated can be irradiated with a uniform amount of the laser. A mechanical drive mechanism in which an initial position is mechanically determined and the moving speed is set to be constant or the distance from the center 31 is set to be constant may be used in place of the drive system 4. In this case, the control by the control device 6 is not required.

As described above, the power density becomes the same at all the irradiation positions of the object 5 to be treated, and the same repeated temperature increase is obtained on the entire surface of the object 5 to be treated. In this case, there is a concern about the influence of a temperature field from the adjacent optical system 2.

However, a semiconductor material basically has a high heat conductivity and enables heat to diffuse instantaneously, and hence heat diffuses and the optical systems 2 are not influenced by the temperature field from the adjacent laser as long as the optical systems 2 are separated by from 10 times to 20 times the beam diameter from each other.

For example, when the beam diameter is 100 µm, it is only required that the optical systems 2 be separated by about 2 mm. Therefore, when a plurality of lasers are disposed, it is only required that the distance between the optical systems 2 be 2 mm or more at the shortest. With this, the plurality of laser beams to be radiated to any portions of the objects 5 to be treated are completely independent from each other, and with one-cycle treatment, the same temperature increase can be given by the number of the optical systems 2.

In this case, temperature fields are formed by irradiation with a plurality of completely independent lasers. The repeated temperature increase means that the peak temperature caused by one laser scanning is temporarily decreased and increased again, and there is no limitation on a decrease width of the peak temperature that is temporarily decreased. Therefore, a plurality of laser irradiation positions may be brought closer to each other as compared to the above-mentioned 10 times to 20 times the beam diameter to allow the temperature fields of the lasers to be influenced by each other to some degree.

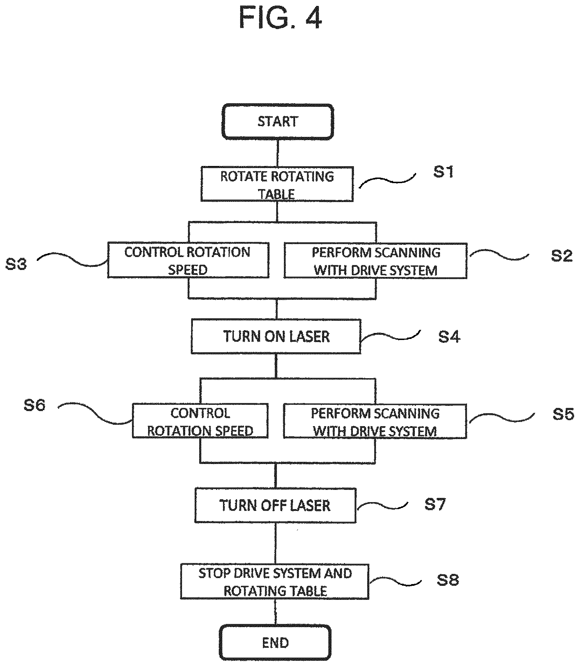

Next, an operation flow of a heat treatment method according to the first embodiment is illustrated in FIG. 4.

As illustrated in FIG. 4, when the operation flow of FIG. 4 is started, the rotation of the rotating table 3 is first started under the control of the control device 6 (Step S1).

When the rotation speed of the rotating table 3 reaches a predefined target value, the drive system 4 starts a drive operation of the optical system 2 to move the optical system 2 to an initial position under the control of the control device 6 (Step S2), and simultaneously, the control of the rotation speed of the rotating table 3 is started under the control of the control device 6 so that the peripheral speed at the irradiation position of the optical system 2 becomes constant (Step S3).

In this case, the control of the rotation speed of the rotating table 3 and the drive position of the optical system 2 is always performed while feedback of the rotation speed and the drive position is given to each other so that the peripheral speed at each irradiation position becomes constant. In this manner, feedback control may be performed so that a constant speed is achieved. Alternatively, feedforward control may be performed because the scanning locus is determined in advance, and hence because the rotation speed and the drive position, at which the peripheral speed at each locus position becomes constant, are uniquely determined.

After the constant-speed operation is started or simultaneously with this, a laser from the laser oscillator 1 is turned on and radiated to the object 5 to be treated (Step S4). In this case, while the laser is radiated with the same output, the drive operation of the drive system 4 and the rotation operation of the rotating table 3 are controlled in the same manner as in Step S2 and Step S3 (Step S5 and Step S6). With this, the peripheral speed at each irradiation position becomes constant, and the power density of the laser at each irradiation position becomes constant. Laser irradiation is repeated two or more times under the above-mentioned irradiation condition.

After the optical system 2 completes scanning of a predefined irradiation area of the object 5 to be treated, the control device 6 turns off the laser (Step S7), and stops the drive system 4 and the rotating table 3 (Step S8) to end the process of the operation flow of FIG. 4.

As described above, the heat treatment device according to the first embodiment includes the laser oscillator 1 configured to produce a laser, one or more optical systems 2 configured to irradiate the object 5 to be treated with the laser produced from the laser oscillator 1, and the table 3 on which the object 5 to be treated is mounted.

When the reaching temperature of the object 5 to be treated, at which the activation rate of the object 5 to be treated reaches the target value through one-time irradiation with the laser, is set as the first temperature, the second temperature lower than the first temperature is set as the target value of the reaching temperature of the object to be treated, and the object 5 to be treated is repeatedly irradiated with the laser from the optical system 2 two or more times.

Specifically, the laser output is set to be constant, and all the optical systems 2 are gradually moved simultaneously from an outer side to the center 31 of the rotating table 3 or moved in a direction opposite thereto by the drive systems 4 so that all the lasers are positioned concentrically.

In addition, while the rotation speed of the rotating table 3 is controlled in accordance with the irradiation position so that the peripheral speed at the irradiation position becomes constant, that is, the beam scanning speeds at all the irradiation positions become constant, the same temperature profile is repeatedly given to the object 5 to be treated. With this, heat treatment can be performed up to a deep position of the object 5 to be treated at a low temperature with high quality and high efficiency without damaging the object 5 to be treated.

### Second Embodiment

In the configuration of the first embodiment described above, the laser oscillator 1 may not be a fiber transmission type LD laser as long as the laser oscillator 1 is a known laser. That is, as the laser oscillator 1, any of a solid-state laser, a gas laser, a fiber laser, and a semiconductor laser may be used. When the laser oscillator 1 is not a fiber transmission type LD laser, a proper optical system 2 is required in each case.

Further, any oscillation system is applicable irrespective of a continuous oscillation type laser and a pulse oscillation type laser. In this case, the optical path does not change in the distance from the laser oscillator 1 to the irradiation position, and hence the configuration of the optical system 2 becomes simpler as compared to that of the first embodiment.

### Third Embodiment

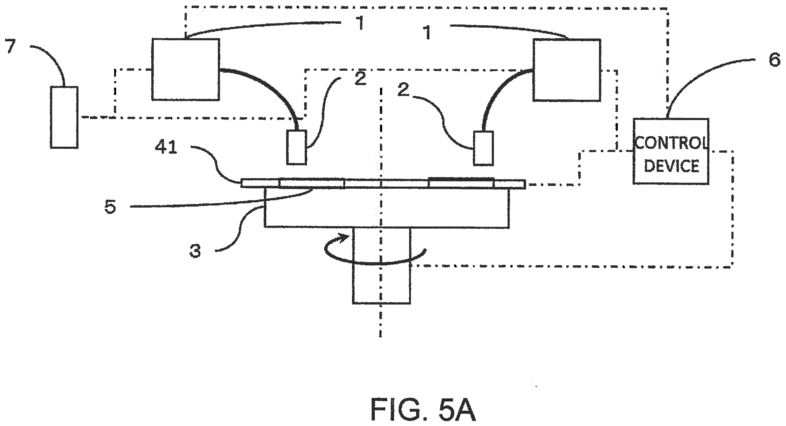

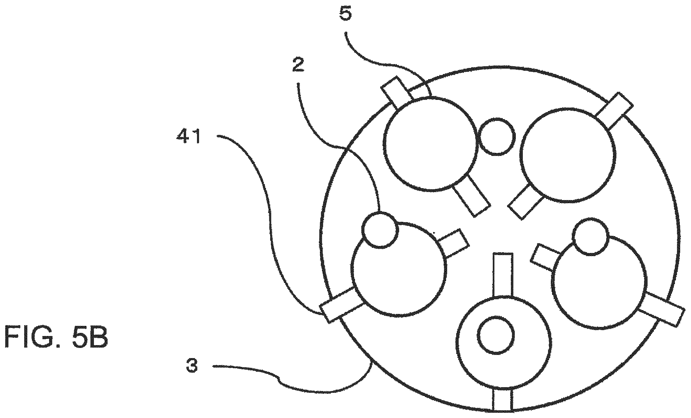

In the above-mentioned first embodiment, the drive system 4 is disposed with respect to the optical system 2, but the drive system may be disposed with respect to the object 5 to be treated. That is, in a third embodiment of the present invention, as illustrated in FIG. 5A and FIG. 5B, a drive system 41 is disposed with respect to the object 5 to be treated. FIG. 5A is a side view of a heat treatment device according to the third embodiment, and FIG. 5B is a plan view of the heat treatment device.

The drive system 41 is disposed in a radial direction of the rotating table 3 so that a longitudinal direction of the drive system 41 is placed along a radius line of the rotating table 3. The drive system 41 moves the object 5 to be treated from the center 31 of the rotating table 3 to an outer side or from the outer side to the center 31 in the radial direction of the rotating table 3.

In this case, the position of the optical system 2 is fixed. As described above, in the third embodiment, the same repeated temperature increase is obtained on the entire surface of the object 5 to be treated by moving the position of the object 5 to be treated by the drive system 41 with respect to the fixed optical system 2.

The other configurations and operations are the same as those of the first embodiment, and hence description thereof is omitted here.

As described above, in the third embodiment, the drive system 41 is disposed with respect to the object 5 to be treated. However, the relative positional relationship between the optical system 2 and the object 5 to be treated can be changed in the same manner as in the first embodiment. As a result, the same effects as those of the first embodiment can be obtained.

That is, also in the third embodiment, in the same manner as in the first embodiment, the laser output is set to be constant, and the objects 5 to be treated are gradually moved simultaneously from an outer side to the center 31 of the rotating table 3 or moved in a direction opposite thereto by the drive systems 41 so that all the lasers are positioned concentrically. Thus, the same temperature profile is repeatedly given to the object 5 to be treated. With this, heat treatment can be performed up to a deep position of the object 5 to be treated at a low temperature with high quality and high efficiency.

In this case, the optical system 2 is fixed, and hence the irradiation position thereof is the same. As a result, the peripheral speed at the irradiation position becomes constant, and hence it is not required to control the rotation speed of the rotating table 3 in accordance with the irradiation position.

Further, when a large number of lasers emitted from the optical system 2 are required, and the number of the objects 5 to be treated is small, the configuration of the third embodiment is simpler. Further, in order to also prevent a change in beam profile being the intensity distribution of a laser from being caused by minute displacement of the optical system 2 due to the movement of the optical system 2 having a complicated configuration, the configuration of the third embodiment is effective.

### Fourth Embodiment

In the configuration of the third embodiment described above, the laser oscillator 1 may not be a fiber transmission type LD laser as long as the laser oscillator 1 is a known laser. That is, as the laser oscillator 1, any of a solid-state laser, a gas laser, a fiber laser, and a semiconductor laser may be used. When the laser oscillator 1 is not a fiber transmission type LD laser, a proper optical system 2 is required in each case.

Further, any oscillation system is applicable irrespective of a continuous oscillation type laser and a pulse oscillation type laser. In this case, the optical path does not change in the distance from the laser oscillator 1 to the irradiation position, and hence the configuration of the optical system 2 becomes simpler as compared to that of the third embodiment.

### Fifth Embodiment

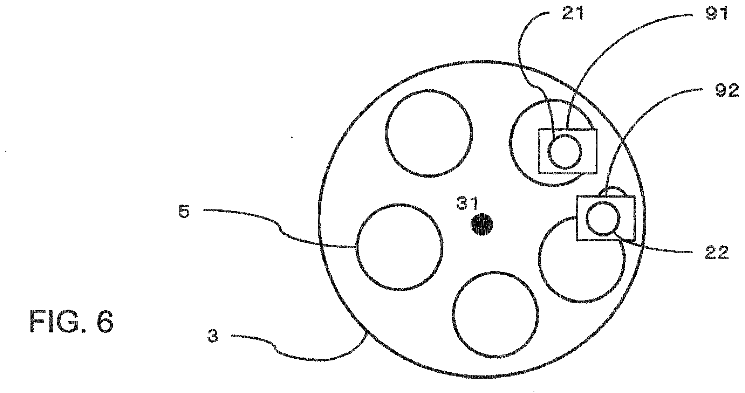

In the configuration of the above-mentioned first embodiment, the optical system 2 is a uniaxial moving mechanism that moves on a radius line. However, in a fifth embodiment of the present invention, as illustrated in FIG. 6, independent drive systems 91 and 92 capable of moving biaxially are disposed with respect to optical systems 21 and 22, respectively. In the fifth embodiment, for simplicity of the drawing, only two optical systems are illustrated, but two or more optical systems may be used.

The other configurations and operations are the same as those of the above-mentioned first embodiment, and hence description thereof is omitted here.

As initial positions, the optical systems 21 and 22 are disposed so that the distances thereof from the center 31 of the rotating table 3 become equal to each other. However, in laser scanning during the treatment, each of the optical systems 21 and 22 is independently moved by the drive system 91, 92 so that the irradiation position of the laser passes along a radius line connecting each of the optical systems 21 and 22 to the center 31. With this, the lasers can be collected in a part of the rotating table 3, with the result that the heat treatment device can be easily maintained, and the device area can be reduced.

Further, in the above-mentioned first embodiment, the optical systems 2 are disposed so as to form an angle of 90° with respect to each other. However, in the fifth embodiment, an interval for disposing the optical systems 2 may be any angle. Further, in the fifth embodiment, the drive systems 91 and 92 may enable the optical systems 2 to move not only in the radial direction but also in the circumferential direction, and in a stage before Step S1 of the operation flow of FIG. 4, the optical systems 2 may be moved in the circumferential direction so that the initial positions thereof in the circumferential direction are changed.

### Sixth Embodiment

In the configuration of the fifth embodiment described above, the laser oscillator 1 may not be a fiber transmission type LD laser as long as the laser oscillator 1 is a known laser. That is, as the laser oscillator 1, any of a solid-state laser, a gas laser, a fiber laser, and a semiconductor laser may be used. When the laser oscillator 1 is not a fiber transmission type LD laser, proper optical systems 2 are required in each case.

Further, any oscillation system is applicable irrespective of a continuous oscillation type laser and a pulse oscillation type laser. In this case, the optical path does not change in the distance from the laser oscillator 1 to the irradiation position, and hence the configuration of the optical systems 2 becomes simpler as compared to that of the fifth embodiment.

### Seventh Embodiment

As illustrated in FIG. 2, the activation rate was increased by repeated irradiation with a laser. However, the improvement ratio of the activation rate is reduced as irradiation is repeated, and an increase in improvement ratio is finally reduced, that is, saturated. Further, the activation rate is only required to be a certain rate or more, and specifically, the activation rate may be, for example, 90 % or more.

Therefore, in a strict sense, it is not required that completely the same temperature increase be repeatedly given, and it is possible to perform various kinds of heat treatment including annealing treatment, in which intended characteristics can be obtained even with some non-uniform temperature increase.

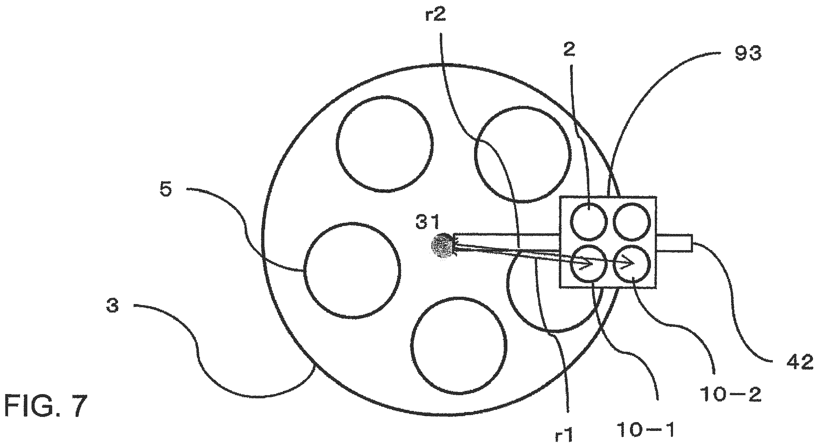

In view of the foregoing, in the configuration of the first embodiment or the third embodiment, as illustrated in FIG. 7, the plurality of optical systems 2 may be collectively mounted on one drive system 93 so that the optical systems 2 are moved by a drive system 42 having the drive system 93 mounted thereon.

The drive system 93 is formed of a rectangular plate-like member enabling all the optical systems 2 to be mounted thereon, and the drive system 42 is formed of an elongated member having a square bar shape corresponding to the drive system 4 illustrated in FIG. 1A and FIG. 1B.

Each of the optical systems 2 can be freely disposed on the drive system 93, and each of the optical systems 2 is disposed so as to have a positional relationship in which a relative difference in peripheral speed at irradiation positions is 30 % or less, that is, a positional relationship in which a relative difference of the distance from the center 31 of the rotating table 3 to the optical system 2 is 30 % or less at any irradiation position.

For example, of the plurality of disposed optical systems 2, the peripheral speed at an irradiation position 10-1 on the center 31 side of the rotating table 3 and the peripheral speed at an irradiation position 10-2 on an outer side from the irradiation position 10-1 have an error of |(r1-r2)/r1|×100 %, where r1 and r2 each represent a rotation radius, that is, a distance from the center 31 to the center of the irradiation position.

When the optical systems 2 further advance to the center 31 side to reach a position closest to the center 31 side, the error reaches a maximum value. That is, when irradiation positions under a state in which the drive system 42 is on an innermost diameter side are represented by 10-1' and 10-2', and rotation radii at those irradiation positions are represented by r1' and r2', a relationship: r1-r1' = r2-r2' holds, and an error of |(r1'-r2')/r1'|×100 % is a maximum speed error in a seventh embodiment of the present invention. The optical systems 2 are disposed so that the maximum speed error reaches 30 % or less.

Also in the seventh embodiment, in the same manner as in the first embodiment, the laser output is set to be constant, and all optical systems 2 are gradually moved simultaneously from an outer side to the center 31 of the rotating table 3 or moved in a direction opposite thereto by the drive system 42 so that all the lasers are positioned concentrically.

In addition, while the rotation speed of the rotating table 3 is controlled in accordance with the irradiation position so that the peripheral speed at the irradiation position becomes constant, that is, the beam scanning speeds at all the irradiation positions become constant, the same temperature profile is repeatedly given to the object 5 to be treated. With this, heat treatment can be performed up to a deep position of the object 5 to be treated at a low temperature with high quality and high efficiency without damaging the object 5 to be treated.

### Eighth Embodiment

In an eighth embodiment of the present invention, in the configurations of the above-mentioned first to seventh embodiments, a scanning speed at a moment is calculated for each irradiation position, and outputs of the laser oscillators 1 are each adjusted so that a value obtained by dividing a power density (W/cm²) being an heat input amount per unit volume by the scanning speed becomes constant.

The other configurations and operations are the same as those of the above-mentioned first embodiment. That is, in the same manner as in each of the above-mentioned embodiments, the eighth embodiment encompasses all the configurations in which the optical system 2 and the object 5 to be treated are relatively moved, and a repeated temperature increase can be given by one-time treatment.

As described above, also in the eighth embodiment, the same effects as those of the above-mentioned first to seventh embodiments can be obtained.

The heat treatment device according to each of the above-mentioned embodiments is applicable to all kinds of heat treatment, such as heating of an object to be treated, as long as the heat treatment involves laser irradiation. Further, the heat treatment device according to each of the above-mentioned embodiments may be used for laser annealing treatment so as to be used as a laser annealing device.

### Ninth Embodiment

In a ninth embodiment of the present invention, in the configurations of the above-mentioned first to eighth embodiments, a scanning speed at a moment is calculated for each irradiation position, and the position of the collimation lens 2a or the objective lens 2b of each of the optical systems 2, 21, and 22 is adjusted so that a value obtained by dividing a power density (W/cm²) being a heat input amount per unit volume by the scanning speed becomes constant, to adjust each beam diameter, that is, each condensed light diameter of a laser.

The other configurations and operations are the same as those of the above-mentioned first embodiment. That is, in the same manner as in each of the above-mentioned embodiments, the ninth embodiment encompasses all the configurations in which the optical system 2 and the object 5 to be treated are relatively moved, and a repeated temperature increase can be given by one-time treatment.

As described above, also in the ninth embodiment, the same effects as those of the above-mentioned first to eighth embodiments can be obtained.

The heat treatment device according to each of the above-mentioned embodiments is applicable to all kinds of heat treatment, such as heating of an object to be treated, as long as the heat treatment involves laser irradiation. Further, the heat treatment device according to each of the above-mentioned embodiments may be used for laser annealing treatment so as to be used as a laser annealing device.

### List of Reference Signs

- 1: laser oscillator
- 2: optical system
- 2a: collimation lens
- 2b: objective lens
- 3: rotating table
- 3a: main body
- 3b: support shaft
- 4: drive system
- 5: object to be treated
- 6: control device
- 7: output measurement instrument
- 8: beam shape measurement instrument
- 21: optical system
- 22: optical system
- 31: center
- 41: drive system
- 91: drive system
- 92: drive system
- 93: drive system

## Claims

1. A heat treatment device, comprising:
- a laser oscillator configured to produce a laser;
- one or more optical systems each configured to irradiate an object to be treated with the laser produced from the laser oscillator; and
- a table on which the object to be treated is to be mounted,
wherein, when a reaching temperature of the object to be treated, at which an activation rate of the object to be treated reaches a target value through one-time irradiation with the laser, is set as a first temperature, a second temperature lower than the first temperature is set as a target value of the reaching temperature of the object to be treated, and the object to be treated is repeatedly irradiated with the laser from one of the one or more optical systems two or more times.

2. The heat treatment device according to claim 1,
wherein the table is formed of a rotating table disposed so as to be rotatable, and the object to be treated is repeatedly irradiated with the laser from one of the one or more optical systems by rotating the rotating table under a state in which the object to be treated is mounted on the rotating table, and
wherein the heat treatment device further comprises a control device configured to control, when a distance between an irradiation position of the laser from one of the one or more optical systems and a center of the rotating table changes, a rotation speed of the rotating table in accordance with the change in the distance so that a peripheral speed of the rotating table is constant at each irradiation position.

3. The heat treatment device according to claim 2,
further comprising a first drive system configured to move the one or more optical systems,
wherein the first drive system is configured to simultaneously move all the one or more optical systems radially by a same distance in a radial direction of the rotating table so that the irradiation positions of the laser from the one or more optical systems are concentrically positioned with respect to the center of the rotating table.

4. The heat treatment device according to claim 2,
further comprising a second drive system configured to move the object to be treated,
wherein the second drive system is configured to simultaneously move all the objects to be treated mounted on the rotating table radially by a same distance in a radial direction of the rotating table.

5. A heat treatment method, comprising:
a laser oscillation step of producing a laser; and
a laser irradiation step of irradiating an object to be treated with the laser produced in the laser oscillation step,
wherein the laser irradiation step includes, when a reaching temperature of the object to be treated, at which an activation rate of the object to be treated reaches a target value through one-time irradiation with the laser, is set as a first temperature, setting a second temperature lower than the first temperature as a target value of the reaching temperature of the object to be treated, and repeatedly irradiating the object to be treated with the laser two or more times.

6. A laser annealing device, which is configured to perform laser annealing treatment for changing characteristics of an object to be treated in a vicinity of a surface of the object to be treated by a temperature increase through irradiation with a laser, the laser annealing device comprising:
a laser oscillator configured to produce the laser;
one or more optical systems each configured to irradiate the object to be treated with the laser produced from the laser oscillator; and
a table on which the object to be treated is to be mounted, wherein, when a reaching temperature of the object to be treated, at which an activation rate of the object to be treated reaches a target value through one-time irradiation with the laser, is set as a first temperature, a second temperature lower than the first temperature is set as a target value of the reaching temperature of the object to be treated, and the object to be treated is repeatedly irradiated with the laser from one of the one or more optical systems two or more times.

7. The laser annealing device according to claim 6,
wherein the irradiation with the laser that is repeatedly performed is performed with a same output and under a same irradiation condition.

8. The laser annealing device according to claim 6 or 7,
wherein each of the one or more optical systems is configured to simultaneously perform irradiation with the laser, and
wherein each of the one or more optical systems is disposed with a gap of 10 times a beam diameter of the laser to be radiated or more so that another adjacent optical system is prevented from being thermally influenced by the laser to be radiated.

9. The laser annealing device according to any one of claims 6 to 8, further comprising a control device configured to set a beam output emitted from each of the one or more optical systems to be constant and to control a relative moving speed between each of the one or more optical systems and the object to be treated to be constant so that a power density of the laser at all irradiation positions irradiated by the one or more optical systems is constant.

10. A laser annealing method of performing laser annealing treatment for changing characteristics of an object to be treated in a vicinity of a surface of the object to be treated by a temperature increase through irradiation with a laser, the laser annealing method comprising:
a laser oscillation step of producing the laser; and
a laser irradiation step of irradiating the object to be treated with the laser produced in the laser oscillation step,
wherein the laser irradiation step includes, when a reaching temperature of the object to be treated, at which an activation rate of the object to be treated reaches a target value through one-time irradiation with the laser, is set as a first temperature, setting a second temperature lower than the first temperature as a target value of the reaching temperature of the object to be treated, and repeatedly irradiating the object to be treated with the laser two or more times.

11. The laser annealing method according to claim 10,
wherein the irradiation with the laser that is repeatedly performed is performed with a same output and under a same irradiation condition.

12. The laser annealing method according to claim 10 or 11,
wherein the irradiation is simultaneously performed with a plurality of lasers, and
wherein each of the plurality of lasers is disposed with a gap of 10 times a beam diameter or more so as to be prevented from being thermally influenced by another adjacent laser.

13. The laser annealing method according to any one of claims 10 to 12, further comprising a control step of setting a beam output of the laser to be constant and controlling a relative moving speed between the laser and the object to be treated to be constant so that a power density of the laser at all irradiation positions irradiated by the laser is constant.

14. The laser annealing method according to any one of claims 10 to 12, further comprising a control step of setting a beam output of the laser to be constant and controlling a condensed light diameter of the laser so that a power density of the laser at all irradiation positions irradiated by the laser is constant.
